# EUROPEAN PATENT APPLICATION

(11) **EP 2 819 270 A1**
(43) Date of publication of application: **31.12.2014**
(21) Application number: 13751858.5
(22) Date of filing: 15.02.2013
(51) Int. Cl.: H02J 13/00, H04L 12/24, H04L 12/70

(54) **NETWORK OVERSEEING DEVICE AND NETWORK OVERSEEING METHOD**

(30) Priority: 20.02.2012 JP 2012034248
(71) Applicant: Kabushiki Kaisha Toshiba, Minato-ku Tokyo 105-8001 (JP)
(72) Inventor: KANEDA, Keiichi, Tokyo 105-8001 (JP); OKUDA, Minoru, Tokyo 105-8001 (JP); NISHIDA, Tomonori, Tokyo 105-8001 (JP)
(74) Representative: Lind, Urban Arvid Oskar
(86) International application number: PCT/JP2013/000828
(87) International publication number: WO 2013/125189

(57) **Abstract**

A network monitoring apparatus includes: a monitor unit monitoring data transmitted in a network monitoring and controlling an electric power system of a transformer substation; a system fault determination database representing a correspondence between a fault in the electric power system and a type of data transmitted in the network; a calculation unit calculating a data amount monitored by the monitor unit; a first determination unit determining whether or not the data amount is greater than a threshold value; a second determination unit determining, when the monitored transmission amount is greater than the threshold value, a presence/absence of an occurrence of system fault based on the system fault determination database and a type of the monitored data; and a stop control unit stopping, when the second determination unit determines that the system fault occurs, the determination carried out in the first determination unit.

## Description

### FIELD

The present invention relates to a network monitoring apparatus and a network monitoring method in a network monitoring and controlling an electric power system of a transformer substation.

### BACKGROUND

In an electric power system, a transformer substation plays an important role for safe, secure, and efficient operation of electric power. In recent years, as a digital technique develops, a digitization of transformer substation monitoring and controlling system that monitors and controls a transformer substation proceeds, and in accordance with that, a configuration in which respective devices configuring the system are coupled by a network, becomes common.

Particularly, an international standard IEC 61850 which has been applied to a transformer substation monitoring and controlling system in recent years is a standard in which data of monitor information, control information, and fault information inside of a transformer substation is transmitted/received via a network, and it is important to monitor a load (traffic) of network to prevent a delay of transmission and a loss of data caused when a transmission capacity exceeds the limit.

Techniques of analyzing components of a network and monitoring an amount of data (traffic) that flows on the network have been disclosed.

### RELEVANT REFERENCES

### Patent References

Reference 1: JP-A 2010-50890
Reference 2: JP-A 2009-17393

### SUMMARY

### PROBLEMS TO BE SOLVED BY THE INVENTION

However, in the techniques described above, even an event particular to a transformer substation (temporary increase in transmission load caused when a system fault occurs) is determined as a transmission overload, so that there is a possibility of erroneous detection.

In a transformer substation, an issuance of alarm due to an erroneous detection greatly hinders normal operational services of the transformer substation, so that there is a need to prevent the erroneous detection as much as possible. Therefore, when monitoring a load of network in a transformer substation, it is required to employ a detection method in which an event particular to the transformer substation is taken into consideration. The present invention has an object to provide a network monitoring apparatus and a network monitoring method designed to reduce an erroneous detection.

### MEANS FOR SOLVING THE PROBLEMS

A network monitoring apparatus according to one embodiment of the present invention includes: a monitor unit monitoring data transmitted in a network monitoring and controlling an electric power system of a transformer substation; a system fault determination database representing a correspondence between a fault in the electric power system and a type of data transmitted in the network; a calculation unit calculating a data amount monitored by the monitor unit; a first determination unit determining whether or not the data amount is greater than a threshold value; a second determination unit determining, when the monitored transmission amount is greater than the threshold value, a presence/absence of an occurrence of system fault based on the system fault determination database and a type of the monitored data; and a stop control unit stopping, when the second determination unit determines that the system fault occurs, the determination carried out in the first determination unit.

### EFFECT OF THE INVENTION

According to the present invention, it is possible to provide a network monitoring apparatus designed to reduce an erroneous detection.

### BRIEF DESCRIPTION OF THE DRAWINGS

FIG. 1 is a diagram illustrating an electric power system of a transformer substation and a transformer substation monitoring and controlling system according to a first embodiment.
FIG. 2 is a block diagram illustrating an outline of network of the transformer substation monitoring and controlling system in FIG. 1.
FIG. 3 is a diagram explaining how a transmission state in a network 20 changes depending on a normal state and a system fault state.
FIG. 4A is a diagram illustrating an example of relationship between a threshold value for network load abnormality detection in a network monitor 61 and occurrences of system fault and communication abnormality.
FIG. 4B is a diagram illustrating an example of relationship between a threshold value for network load abnormality detection in the network monitor 61 and occurrences of system fault and communication abnormality.
FIG. 5 is a flow chart illustrating an example of load determination processing of network in the network monitor 61 according to the first embodiment.
FIG. 6 is a block diagram illustrating an outline of network of a transformer substation monitoring and controlling system according to a modified example of the first embodiment.
FIG. 7 is a flow chart illustrating an example of load determination processing of network in a network monitor 61 according to the modified example of the first embodiment.
FIG. 8 is a block diagram illustrating an outline of network of a transformer substation monitoring and controlling system according to a second embodiment.
FIG. 9 is a flow chart illustrating an example of load determination processing of network in a network monitor 61 according to the second embodiment.
FIG. 10 is a block diagram illustrating an outline of network of a transformer substation monitoring and controlling system according to a third embodiment.
FIG. 11 is a block diagram illustrating an outline of network of a transformer substation monitoring and controlling system according to a modified example of a fourth embodiment.
FIG. 12 is a block diagram illustrating an outline of network of a transformer substation monitoring and controlling system according to a fifth embodiment.
FIG. 13 is a block diagram illustrating an outline of network of a transformer substation monitoring and controlling system according to a sixth embodiment.
FIG. 14 is a block diagram illustrating an outline of network of a transformer substation monitoring and controlling system according to a seventh embodiment.
FIG. 15 is an example illustrating a relationship between trend data of a transmission data amount and threshold values.

### DETAILED DESCRIPTION

Hereinafter, embodiments of the present invention will be described in detail while referring to the drawings.

### (First embodiment)

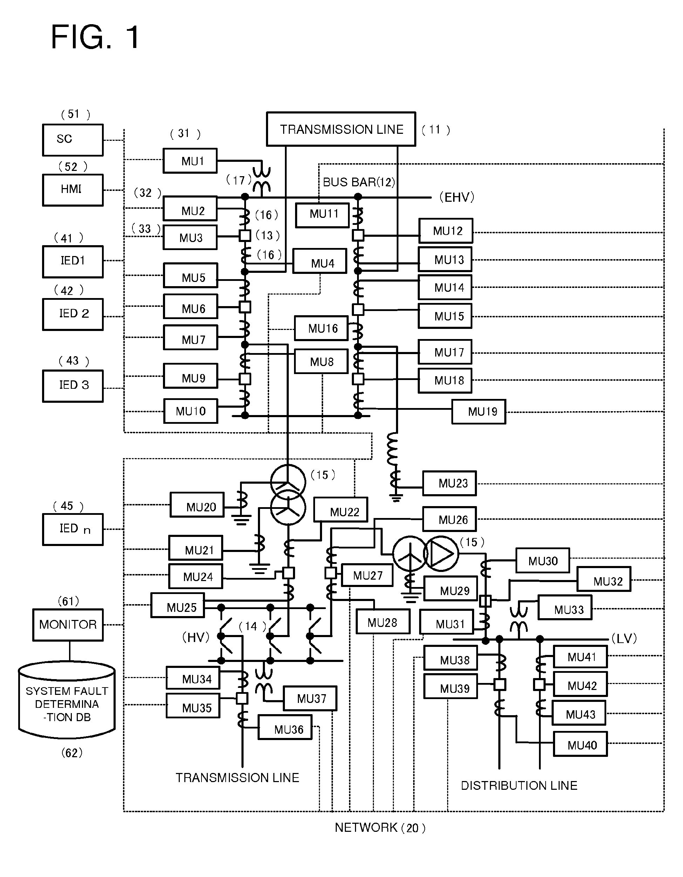

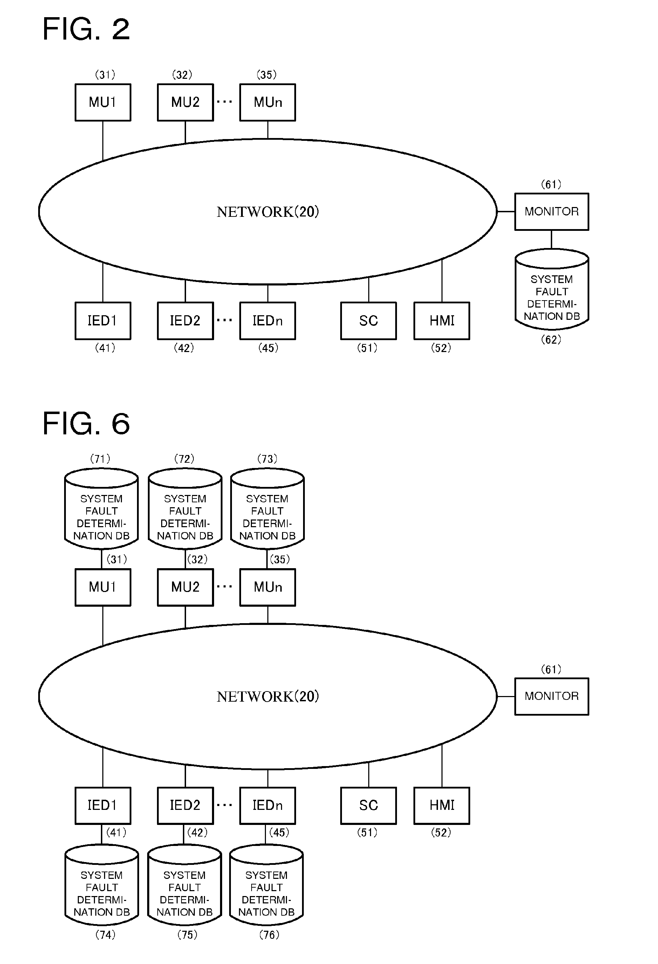

FIG. 1 is a diagram illustrating an electric power system of a transformer substation and a transformer substation monitoring and controlling system according to a first embodiment. FIG. 2 is a block diagram illustrating an outline of network of the transformer substation monitoring and controlling system in FIG. 1.

In the electric power system of the transformer substation according to the present embodiment, a voltage of a transmission line (ultra-high voltage transmission line) 11 is sequentially lowered and made to be constant by two transformer 15, and supplied to a transmission line and a distribution line. This electric power system is configured by the transmission line 11, a bus bar 12, a circuit breaker 13, a disconnecting switch 14, the transformer 15, CTs (Current Transformers) 16, a VT (Voltage transformer) 17 and the like.

The transmission line 11 is an electric wire through which an electric power is supplied from a power station to the transformer substation. The bus bar 12 is an electric wire through which an electricity from the transmission line 11 is supplied to the transformer 15 and the like via the circuit breaker 13 and the disconnecting switch 14. The circuit breaker 13 is an electric power device that opens/closes a load current of the bus bar 12 at a time of normal operation. The disconnecting switch 14 is an electric power device that opens/closes a voltage of the bus bar 12 when no load is applied. The transformer 15 is an electric power device that transforms a voltage. The CT 16 is an electric power device that measures a current of the bus bar 12 by transforming the current into a low current. The VT 17 is an electric power device that measures a voltage of the bus bar 12 by transforming the voltage into a low voltage (110 V, for example).

The transformer substation monitoring and controlling system is one for monitoring the transformer substation, and has a network 20, MUs (31 to 35), IEDs (41 to 45), a SC 51, a HMI 52, a network monitor 61, and a system fault determination database 62.

The network 20 is an information transmission line connecting the MUs (31 to 35), the IEDs (41 to 45), the SC 51, the HMI 52, and the network monitor 61, and transmits various types of data.

The MUs (Merging Units) (31 to 33) are devices connected to the components (the circuit breaker 13, the disconnecting switch 14, the CT 16, and the VT 17) of the electric power system, and collecting data from these components. The components of the electric power system are connected to a MU 1 (31) to a MU n (35), respectively, in such a manner that "the VT 17 is connected to the MU 1 (31), the CT 16 is connected to a MU 2 (32), and the circuit breaker 13 is connected to a MU 3 (33)", for example. The data collected by the MUs (31 to 35) is transmitted to any one of the IEDs (41 to 45).

The IEDs (Intelligent Electronic Devices) (41 to 45) are protective relays, and are also generally called as Intelligent Electronic Devices (IEDs). The IEDs (41 to 45) receive information from the MUs (31 to 35), and transmit the information to the SC 51.

The SC (Station Computer) 51 is a computer that monitors and controls a state of the entire transformer substation. The HMI (Human Machine Interface) 52 is an interface (input/output device) between the SC 51 and an operator, and has a display device, an information input device and the like.

The network monitor 61 is connected to the network 20, and monitors a load condition of the network 20. The network monitor 61 can monitor data transmitted among the devices (the IEDs (41 to 45), the MUs (31 to 35), the SC 51, and the HMI 52) connected to the network 20. Specifically, the network monitor 61 functions as a monitor unit monitoring the data transmitted in the network monitoring and controlling the electric power system of the transformer substation.

The data transmitted in the network 20 is transmitted from a transmission-side device as a packet including a header (a transmission-side address, a reception-side address and the like) and a data body. For this reason, by monitoring a signal on the network 20, it is possible to know a transmission-side device, a reception-side device, a content of data, and a data amount in each packet.

The network monitor 61 calculates the monitored data amount. Specifically, the network monitor 61 functions as a calculation unit calculating the data amount monitored by the monitor unit. This calculation is conducted at a predetermined interval of 1 second unit, 100 m/second unit or the like, for example.

At this time, the network monitor 61 can calculate the total amount of data transmitted in the network 20. Further, the network monitor 61 may also calculate a data amount for each transmission-side device (or for each reception-side device). As described above, the device performing transmission/reception can be determined based on the information of the header (address) of the packet.

The network monitor 61 determines whether or not the calculated data amount is greater than a threshold value. Specifically, the network monitor 61 functions as a first determination unit determining whether or not the data amount is greater than the threshold value.

The network monitor 61 determines, when the monitored transmission amount is greater than the threshold value, a presence/absence of an occurrence of system fault based on the system fault determination database and a type of the monitored data. Specifically, the network monitor 61 functions as a second determination unit determining, when the monitored transmission amount is greater than the threshold value, the presence/absence of the occurrence of system fault based on the system fault determination database and the type of the monitored data. Note that details thereof will be described later.

The network monitor 61 can stop, when the second determination unit determines that the system fault occurs, the determination carried out in the first determination unit. Specifically, the network monitor 61 functions as a stop control unit stopping, when the second determination unit determines that the system fault occurs, the determination carried out in the first determination unit.

Here, for easier explanation, the network monitor 61 is illustrated by being independent from other devices (the IEDs (41 to 45), the MUs (31 to 35), the SC 51, the HMI 52 and the like). It is also possible that the function of the network monitor 61 is implemented in the IEDs (41 to 45), the MUs (31 to 35), the SC 51 or the HMI 52.

The system fault determination database 62 is a database for determining a system fault when monitoring a network load in the network monitor 61. The system fault determination database 62 represents a correspondence between a fault in the electric power system and a type of data transmitted in the network 20. Specifically, the database holds patterns of data representing types of data corresponding to faults in the electric power system (for example, data for notifying an occurrence of fault in the electric power system, data representing a type of the occurred fault, data for identifying a device detecting the occurred fault (the IEDs (41 to 45), the MUs (31 to 35)), control data for dealing with the fault, and the like).

In the present embodiment, when detecting a load abnormality in the network 20, the system fault determination database 62 is used to determine the presence/absence of the occurrence of system fault. The network monitor 61 can determine the presence/absence of the occurrence of system fault based on whether or not the monitored transmission data matches the pattern of data represented in the system fault determination database 62. Further, the network monitor 61 can determine the type of system fault, and the device detecting the occurred fault.

Hereinafter, the reason why the determination of the presence/absence of the occurrence of system fault is required when detecting the load abnormality in the network 20, will be described.

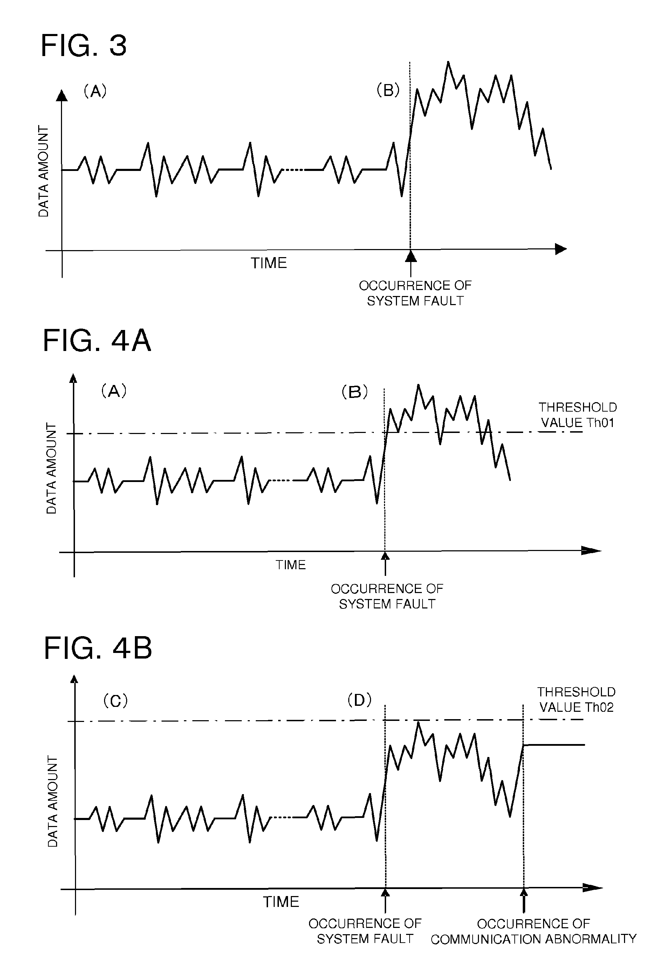

FIG. 3 is a diagram explaining how a transmission state in the network 20 changes depending on a normal state and a system fault state. (A) and (B) in FIG. 3 indicate the normal state and the system fault occurrence state, respectively.

### (1) Communication state inside of network 20 under normal state ((A) in FIG. 3)

The communication state inside of the network 20 under normal state is as follows. Data communicated from the MU 35 to the IED 45 occupies a large part, and an amount of data other than the above, for example, data communicated among the following devices a) to e), is small.
a) From the IEDs (41 to 45) to the MUs (31 to 35)
b) From the IEDs (41 to 45) to the SC 51
c) From the SC 51 to the IEDs (41 to 45)
d) From the SC 51 to the MUs (31 to 35)
e) From the SC 51 to the HMI 52

Further, although the data amount varies more or less, it does not change greatly (the data amount is approximately constant).

### (2) Communication state inside of network 20 when system fault occurs ((B) in FIG. 3)

When the system fault occurs, the following communication is conducted among the devices a) to e), other than the communication from the MU 35 to the IED 45.
1) An instruction of removing the system fault is transmitted from the IEDs (41 to 45) to the MUs (31 to 35), and a turn-off instruction is output from the MUs (31 to 35) to the circuit breaker 13. Together with the above, data after the circuit breaker 13 is turned off is transmitted from the MUs (31 to 35) to the IEDs (41 to 45). Specifically, a data amount transmitted between the IEDs (41 to 45) and the MUs (31 to 35) is increased.
2) Alternatively, system fault information from the IEDs (41 to 45) is transmitted to the SC 51, and further, the information is transmitted from the SC 51 to the HMI 52 to be displayed with respect to an operator. Specifically, a data amount transmitted from the IEDs (41 to 45) to the SC 51 and a data amount transmitted from the SC 51 to the HMI 52 are increased.

Therefore, the graph of the amount of data that flows on the network and the time ((B) in FIG. 3) exhibits a trend different from that of the graph under the normal state ((A) in FIG. 3), and the data amount is temporarily increased from a point of time of the occurrence of system fault.

Note that in accordance with a system event to be occurred, a transmission data amount transmitted from each of the MUs (31 to 35) and the IEDs (41 to 45) becomes different, and further, in accordance with each event, a data amount transmitted by the IEDs (41 to 45) and the MUs (31 to 35) also becomes different.

FIG. 4A and FIG. 4B are diagrams each illustrating an example of relationship between a threshold value for network load abnormality detection in the network monitor 61 and occurrences of system fault and communication abnormality. (A) in FIG. 4A and (C) in FIG. 4B indicate a normal state, and (B) in FIG. 4A and (D) in FIG. 4B indicate a system fault occurrence state. In (A) and (B), a threshold value Th01 estimated from the normal state is set, and in (C) and (D), a threshold value Th02 which is greater than the threshold value Th01 is set, by taking the time of system fault into consideration. It is supposed to detect a communication abnormality by comparing these threshold values Th01 and Th02 with the data amount transmitted/received on the network 20.

As illustrated in (A) and (B) in FIG. 4A, when the threshold value Th01 set based on the data amount under the normal state is employed, if the system fault occurs, the data transmission amount is temporarily increased, so that there is a possibility that the communication abnormality is erroneously detected.

On the other hand, as illustrated in (C) and (D) in FIG. 4B, when the threshold value Th02 set based on the data amount under the system fault occurrence state is employed, it is possible to reduce the erroneous detection of communication abnormality when the system fault occurs. However, if there is no large difference between the data amount at the time of system fault and the data amount at the time of communication abnormality, there is a possibility that the communication abnormality cannot be detected. As described above, in order to clearly discriminate the time of system fault and the time of communication abnormality, it is desirable to determine the presence/absence of the system fault.

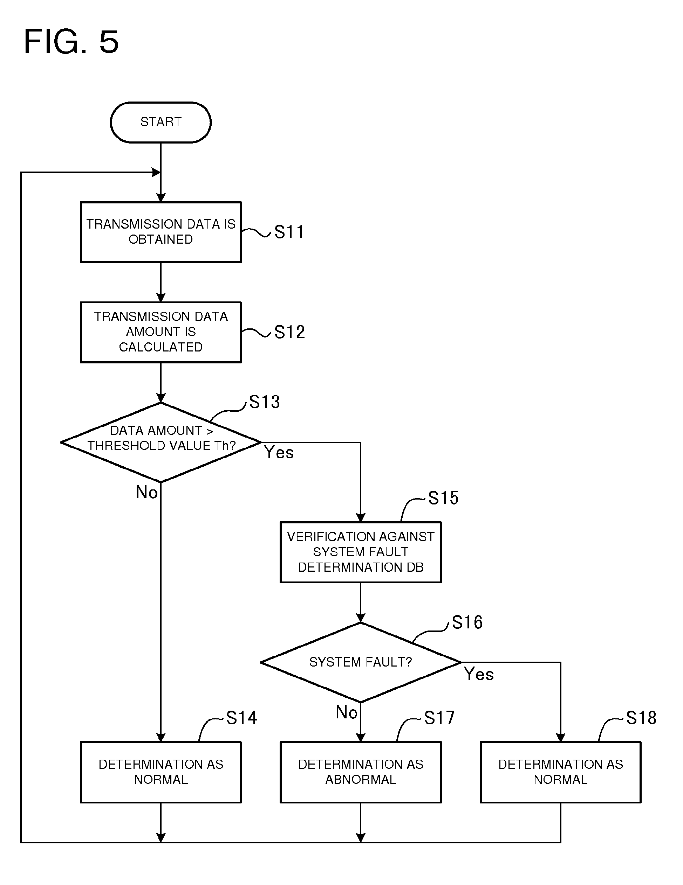

FIG. 5 is a flow chart illustrating an example of load determination processing of network in the network monitor 61 according to the present embodiment.
(1) The network monitor 61 obtains data that flows on the network 20 (step S11), and calculates a transmission data amount (step S12). For example, a total amount of data at every predetermined interval is calculated.
(2) A previously set threshold value Th and the calculated transmission data amount are compared (step S13). This threshold value Th is a temporary standard regarding whether or not the transmission data amount is excessive (presence/absence of communication abnormality). However, since there is a possibility of erroneous detection of communication abnormality with the use of only the threshold value Th, as described above, the determination of presence/absence of the occurrence of system fault is also used in a combined manner, as will be described later.
(3) When the transmission data amount does not exceed the threshold value Th, it is determined as normal (no communication abnormality is detected) (step S14).
(4) When the transmission data amount exceeds the threshold value Th, the transmitted data is verified against the system fault determination database 62 (step S 15), and the presence/absence of the occurrence of system fault is determined (step S16). As described above, it is possible to determine the presence/absence of the occurrence of system fault based on whether or not the monitored transmission data matches the pattern of data represented in the system fault determination database 62.
(5) When no system fault occurs, since the transmission data amount exceeds the threshold value Th, it is determined that the transmission load is abnormal (communication abnormality is detected) (step S17). When it is determined that the system fault occurs, even if the transmission data amount exceeds the threshold value Th, it is determined as normal (no communication abnormality is detected) (step S18). In this case, it is also possible to stop the detection of communication abnormality carried out by the network monitor 61.

In a manner as described above, at the time of the occurrence of system fault, it becomes possible to temporarily stop the network monitoring function performed by the network monitor 61, resulting in that the erroneous detection of communication abnormality can be prevented.

### (Modified example of first embodiment)

FIG. 6 is a block diagram corresponding to FIG. 2, and illustrating an outline of network of a transformer substation monitoring and controlling system according to a modified example of the first embodiment.

In this case, system fault determination databases (71 to 76) are connected to the MUs (31 to 35) and the IEDs (41 to 45), respectively. The MUs (31 to 35) and the IEDs (41 to 45) respectively determine whether or not the system fault occurs, by using the system fault determination databases (71 to 76), and notify the network monitor 61 of results of the determination via the network 20. As a result of this, it is possible to determine the system fault even if the system fault determination database 62 is not mounted on the network monitor 61.

Note that the system fault determination in the IEDs (41 to 45) and the MUs (31 to 35) may also be realized, not by the way of mounting the databases (71 to 76), but as functions of the IEDs (41 to 45) and the MUs (31 to 35) themselves.

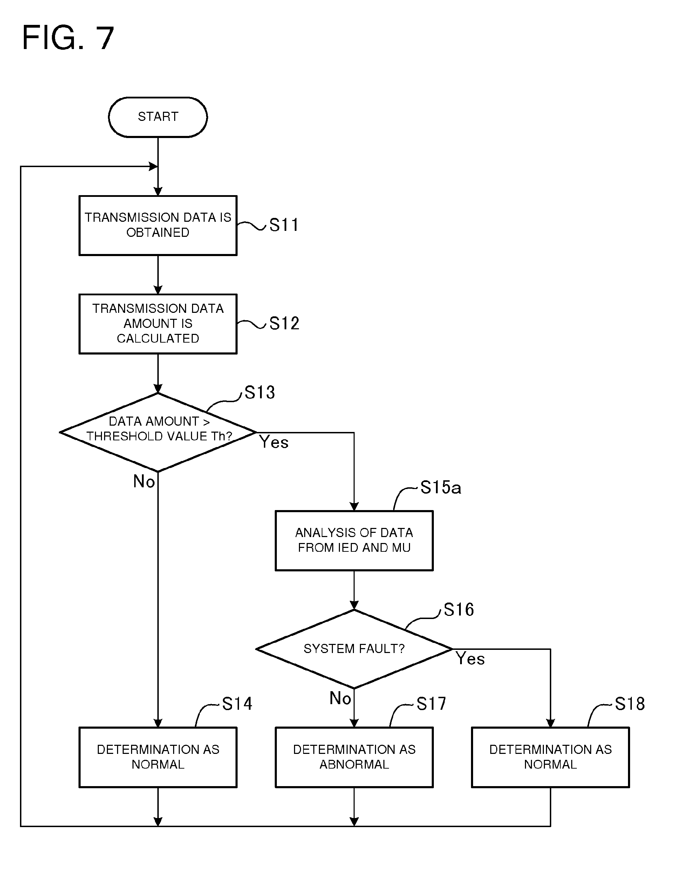

FIG. 7 is a flow chart illustrating an example of load determination processing of network in the network monitor 61 according to the present embodiment. In this case, the network monitor 61 analyzes data transmitted from the IEDs (41 to 45) and the MUs (31 to 35) (step S15a), and determines whether or not the system fault occurs (step S16). The present modified example is not substantially different from the first embodiment except for this point, so that detailed explanation will be omitted.

### (Second embodiment)

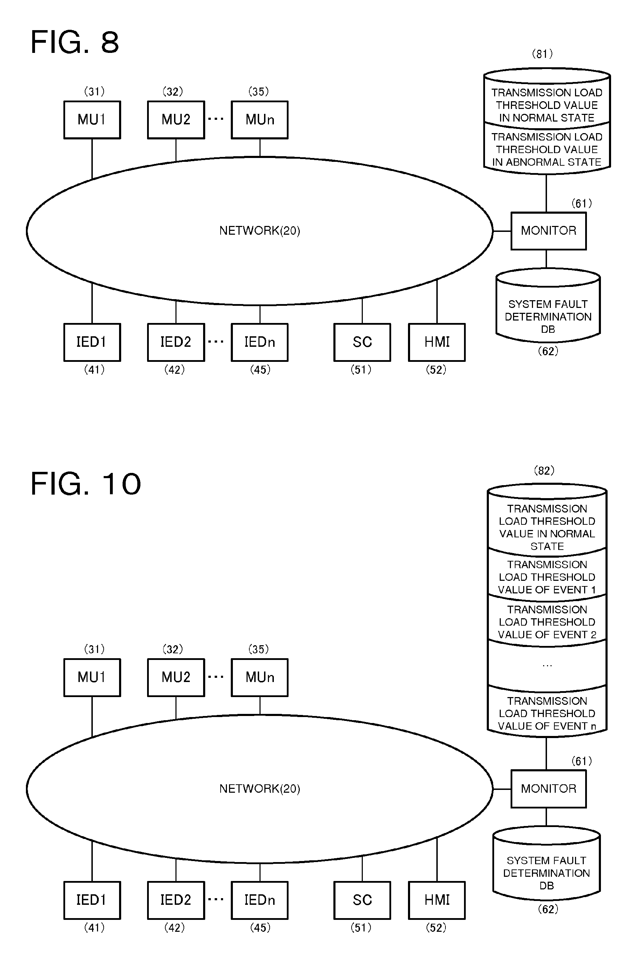

FIG. 8 is a block diagram corresponding to FIG. 2, and illustrating an outline of network of a transformer substation monitoring and controlling system according to a modified example of a second embodiment.

In this case, a storage unit 81 storing two types of threshold values (a transmission load threshold value Th1 in normal state (in normal operation state), and a transmission load threshold value Th2 in abnormal state (when system fault occurs)), is connected to the network monitor 61. Generally, the threshold value Th2 is greater than the threshold value Th1.

As described above, it becomes possible to prevent the erroneous detection caused by the system fault (refer to FIG. 4A and FIG. 4B) by providing the two types of threshold values and switching the respective threshold values in accordance with the state, and to detect, after the fault, the load abnormality when the system fault occurs by switching the threshold value to the threshold value Th1 in the normal state.

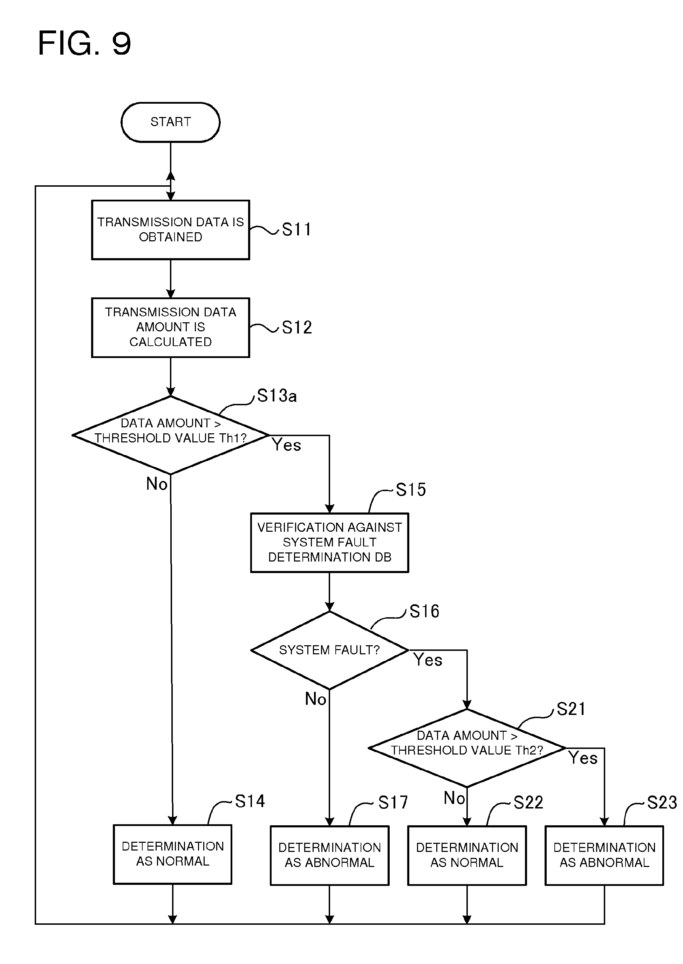

FIG. 9 is a flow chart illustrating an example of load determination processing of network in the network monitor 61 according to the present embodiment.
(1) The network monitor 61 obtains data that flows on the network 20 (step S11), and calculates a transmission data amount (step S12). For example, a total amount of data at every predetermined interval is calculated.
(2) The transmission load threshold value Th1 in the normal state and the calculated transmission data amount are compared (step S13a). This threshold value Th1 is a temporary standard regarding whether or not the transmission data amount is excessive (presence/absence of communication abnormality).
(3) When the transmission data amount does not exceed the threshold value Th1, it is determined as normal (no communication abnormality is detected) (step S14).
(4) When the transmission data amount exceeds the threshold value Th1, the transmitted data is verified against the system fault determination database 62 (step S 15), and the presence/absence of the occurrence of system fault is determined (step S16). As described above, it is possible to determine the presence/absence of the occurrence of system fault based on whether or not the monitored transmission data matches the pattern of data represented in the system fault determination database 62.
(5) When no system fault occurs, since the transmission data amount exceeds the threshold value Th1, it is determined that the transmission load is abnormal (communication abnormality is detected) (step S17). When it is determined that the system fault occurs, a determination is made whether the transmission data amount exceeds the threshold value Th2 in the abnormal state (step S21). If it is determined that the transmission data amount does not exceed the threshold value Th2 in the abnormal state, the determination is made as normal (step S22). When the transmission data amount exceeds the threshold value Th2 in the abnormal state, the determination is made as abnormal (step S23).

In the present embodiment, by performing the determination at the time of the occurrence of system fault by switching the threshold value from the threshold value Th1 in the normal state to the threshold value Th2 in the abnormal state, it is possible to prevent the erroneous detection.

Note that it is also possible to mount the system fault determination databases (71 to 75) on the IEDs (41 to 45) and the MUs (31 to 35), as in the modified example of the first embodiment. In this case, it is also possible to determine whether or not the system fault occurs in the respective IEDs (41 to 45) and MUs (31 to 35), and notify the network monitor 61 of results of the determination, thereby determining the system fault. This can also be applied to third to seventh embodiments, other than the second embodiment.

### (Third embodiment)

FIG. 10 is a block diagram corresponding to FIG. 2 and illustrating an outline of network of a transformer substation monitoring and controlling system according to a third embodiment.

In this case, a storage unit 82 storing threshold values for respective types of system events, is connected to the network monitor 61. As described above, the data amount is different in accordance with the system event to be occurred (refer to FIG. 3). The threshold values in accordance with the system events to be occurred are provided, and the threshold value is switched in accordance with a determination result obtained by using the system fault determination database 62. As a result of this, it becomes possible to prevent the erroneous detection caused by the system fault, and to detect, after the fault, the load abnormality when the communication abnormality occurs by switching the threshold value to the threshold value Th1 in the normal state.

An example of load determination processing of network in the network monitor 61 according to the present embodiment can be represented by the flow chart in FIG. 9. In the present embodiment, when it is determined that the system fault occurs, the occurred event is verified against the system fault determination database 62. Further, the threshold value is switched from the threshold value Th1 in the normal state to the threshold value Th2 in accordance with the occurred event, and it is determined whether the data amount exceeds that threshold value Th2 (step S21). The present embodiment is not greatly different from the second embodiment in the other points, so that detailed explanation will be omitted.

In the present embodiment, it becomes possible to perform the determination at the time of the occurrence of system fault by switching the threshold value from the threshold value in the normal state to the threshold value in accordance with the occurred event, resulting in that it is possible to prevent the erroneous detection, and to more accurately determine a transmission abnormality caused by a device abnormality.

### (Fourth embodiment)

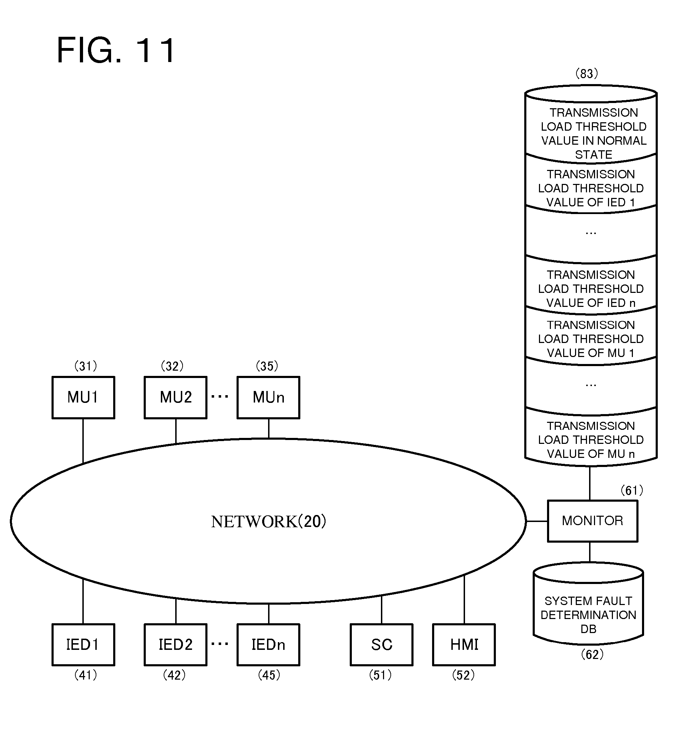

FIG. 11 is a block diagram corresponding to FIG. 2 and illustrating an outline of network of a transformer substation monitoring and controlling system according to a fourth embodiment.

In the present embodiment, a storage unit 83 storing a threshold value for each device detecting the system fault, is connected to the network monitor 61. As described above, the data amount transmitted from each device is different in accordance with the system event to be occurred (refer to FIG. 3). The threshold value is provided for each device detecting the system fault, and each threshold value is switched in accordance with a determination result obtained by using the system fault determination database 62. As a result of this, it becomes possible to prevent the erroneous detection caused by the system fault, and to detect, after the fault, the load abnormality when the communication abnormality occurs by switching the threshold value to the threshold value in the normal state.

An example of load determination processing of network in the network monitor 61 according to the present embodiment can be represented by the flow chart in FIG. 9. In the present embodiment, when it is determined that the system fault occurs, a device detecting the occurrence of system fault is checked from the system fault determination database 62. Further, the threshold value is switched from the threshold value Th1 in the normal state to the threshold value Th2 for each device. Further, a transmission data amount transmitted from the device detecting the occurrence of system fault is calculated, and it is determined whether the transmission data amount exceeds that threshold value Th2 for each device (step S21). The present embodiment is not greatly different from the second embodiment in the other points, so that detailed explanation will be omitted.

In the present embodiment, it becomes possible to perform the determination at the time of the occurrence of system fault by switching the threshold value from the threshold value in the normal state to the threshold value for each device detecting the occurrence of system fault, resulting in that it is possible to prevent the erroneous detection, and to more accurately determine a transmission abnormality caused by a device abnormality.

### (Fifth embodiment)

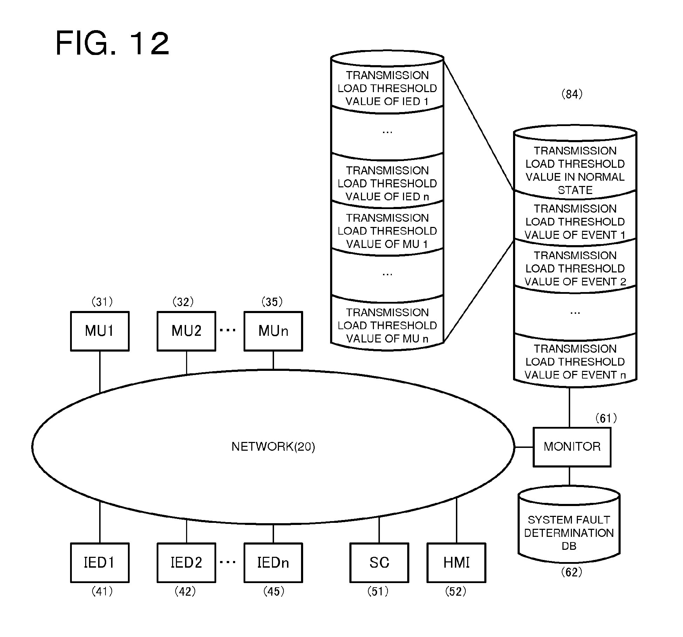

FIG. 12 is a block diagram corresponding to FIG. 2 and illustrating an outline of network of a transformer substation monitoring and controlling system according to a fifth embodiment.

In the present embodiment, a storage unit 84 storing a threshold value for each type of occurred system event and for each device, is connected to the network monitor 61. As described above, the data amount transmitted in accordance with the system events to be occurred and transmitted from each device for each of those events is different (refer to FIG. 3). The threshold value is provided for each of the system events and for each device detecting the system fault in accordance with each of those events, and each threshold value is switched in accordance with a determination result obtained by using the system fault determination database 62. As a result of this, it becomes possible to prevent the erroneous detection caused by the system fault, and to more accurately detect, after the fault, the load abnormality when the communication abnormality occurs by switching the threshold value to the threshold value in the normal state.

An example of load determination processing of network in the network monitor 61 according to the present embodiment can be represented by the flow chart in FIG. 9. In the present embodiment, when it is determined that the system fault occurs, the type of occurred system event is determined from the system fault determination database 62, and a device detecting the occurrence of system fault is checked. Further, the threshold value is switched from the threshold value Th1 in the normal state to the threshold value Th2 for each type of event and for each device. Further, a transmission data amount transmitted from the device detecting the occurrence of system fault is calculated, and it is determined whether the transmission data amount exceeds that threshold value Th2 for each type of event and for each device (step S21). The present embodiment is not greatly different from the second embodiment in the other points, so that detailed explanation will be omitted.

In the present embodiment, it becomes possible to perform the determination at the time of the occurrence of system fault by switching the threshold value from the threshold value in the normal state to the threshold value for each type of system event and for each device detecting the occurrence of system fault, resulting in that it is possible to prevent the erroneous detection, and to more accurately determine a transmission abnormality caused by a device abnormality.

### (Sixth embodiment)

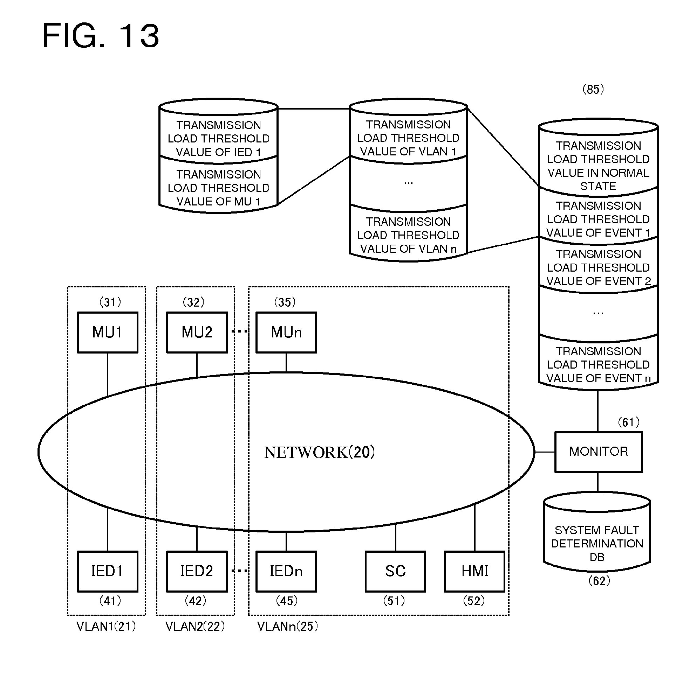

FIG. 13 is a block diagram corresponding to FIG. 2 and illustrating an outline of network of a transformer substation monitoring and controlling system according to a sixth embodiment.

The network 20 is divided into virtual networks of respective devices from VLAN 1 (21), VLAN 2 (22), to VLAN n (25). To the network monitor 61, a storage unit 85 storing a threshold value in accordance with each type of occurred system events, each of the virtual networks VLAN 1 (21) to VLAN n (25), and each device configuring each virtual network (in a case of the VLAN 1 (21), the IED 1 (41) and the MU 1 (31), for example), is connected.

As described above, the data amount transmitted in accordance with the system events to be occurred and transmitted from each device for each of those events is different. The devices which are relevant to each other are classified by the virtual networks (21 to 25), the threshold value is provided for each of the system events and for each device detecting the system fault in accordance with each of those events, and the threshold value is switched in accordance with a determination result obtained by using the system fault determination database 62. As a result of this, it becomes possible to prevent the erroneous detection caused by the system fault, and to more accurately detect, after the fault, the load abnormality when the communication abnormality occurs by switching the threshold value to the threshold value in the normal state.

An example of load determination processing of network in the network monitor 61 according to the present embodiment can be represented by the flow chart in FIG. 9. In the present embodiment, when it is determined that the system fault occurs, the type of occurred system event is determined from the system fault determination database 62, and a device detecting the occurrence of system fault is checked. Further, the threshold value is switched from the threshold value Th1 in the normal state to the threshold value Th2 for each virtual network, for each type of event, and for each device. Further, a transmission data amount transmitted from the device detecting the occurrence of system fault is calculated, and it is determined whether the transmission data amount exceeds that threshold value Th2 for each type of event and for each device (step S21). The present embodiment is not greatly different from the second embodiment in the other points, so that detailed explanation will be omitted.

In the present embodiment, by classifying the devices which are relevant to each other by the virtual network groups, the threshold value can be set for each of the devices which are relevant to each other, so that it becomes possible that the system events and the devices responding to the system events are managed by being related to each other.

### (Seventh embodiment)

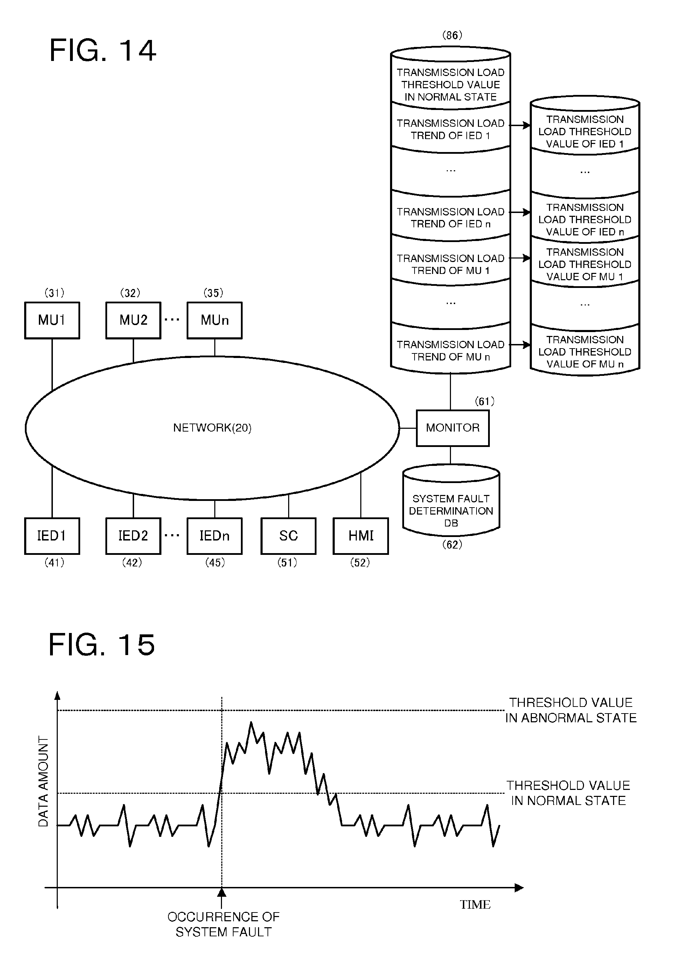

FIG. 14 is a block diagram corresponding to FIG. 2 and illustrating an outline of network of a transformer substation monitoring and controlling system according to a seventh embodiment. In the present embodiment, a storage unit 85 storing trend data of a transmission data amount of each device (the IED 1 (41) to the IED n (45), the MU 1 (31) to the MU n (35)) configuring the system, is connected to the network monitor 61, and threshold values are set for each device by using the trend data.

As described above, the data amount transmitted in accordance with the system events to be occurred and transmitted from each device for each of those events is different. Previously calculated theoretical values are not used for the setting of threshold values, but the threshold values for each device previously calculated from the trend data of the past event are prepared, and each threshold value is switched in accordance with a determination result obtained by using the system fault determination database 62. As a result of this, it becomes possible to prevent the erroneous detection caused by the system fault, and to more accurately detect the load abnormality when the communication abnormality occurs.

FIG. 15 is an example illustrating a relationship between the trend data of the transmission data amount and threshold values. It is possible that the trend data of data amount as in the present example is individually stored for each device (the IED 1 (41) to the IED n (45), the MU 1 (31) to the MU n (35)) configuring the system, and a threshold value in the normal state and a threshold value in the abnormal state are decided based on the data. By calculating the threshold values by using, not the previously calculated theoretical values but the actual data, it is possible to realize the setting of threshold values with higher accuracy, and to realize the prevention of erroneous detection of transmission load and the detection with high accuracy. Note that the threshold values can also be calculated for each system event as illustrated in the fifth embodiment, and in that case, a fmer determination can be realized.

### (Other embodiments)

The embodiments of the present invention are not limited to the above-described embodiments and can be extended and modified, and the extended and modified embodiments are also included in the technical scope of the present invention.

## Claims

1. A network monitoring apparatus, comprising:
a monitor unit configured to monitor data transmitted in a network monitoring and controlling an electric power system of a transformer substation;
a system fault determination database configured to represent a correspondence between a fault in the electric power system and a type of data transmitted in the network;
a calculation unit configured to calculate a data amount monitored by the monitor unit;
a first determination unit configured to determine whether or not the data amount is greater than a threshold value;
a second determination unit configured to determine, when the monitored transmission amount is greater than the threshold value, a presence/absence of an occurrence of system fault based on the system fault determination database and a type of the monitored data; and
a stop control unit configured to stop, when the second determination unit determines that the system fault occurs, the determination carried out in the first determination unit.

2. The network monitoring apparatus according to claim 1, further comprising
a third determination unit configured to determine, when the second determination unit determines that the system fault occurs, the presence/absence of the occurrence of system fault based on whether or not the monitored transmission amount is greater than a second threshold value which is greater than the threshold value.

3. The network monitoring apparatus according to claim 2,
wherein the system fault determination database represents a correspondence between a type of fault in the electric power system and the type of data transmitted in the network;
when the monitored transmission amount is greater than the threshold value, the second determination unit determines the presence/absence of the occurrence of system fault and the type of fault based on the type of the monitored data and the system fault determination database; and
the second threshold value corresponds to the determined type of the fault.

4. The network monitoring apparatus according to claim 2,
wherein the network transmits communications among a plurality of types of devices; and
wherein the second threshold value corresponds to the type of the device.

5. The network monitoring apparatus according to claim 2,
wherein the network is divided into a plurality of networks; and
wherein the second threshold value corresponds to each of the plurality of networks.

6. The network monitoring apparatus according to claim 2, further comprising:
a trend data accumulation unit configured to accumulate data transmitted in the network as trend data; and
a decision unit configured to decide the threshold value and the second threshold value based on the accumulated trend data.

7. A network monitoring method, comprising:
monitoring data transmitted in a network monitoring and controlling an electric power system of a transformer substation;
calculating the monitored data amount;
determining whether or not the data amount is greater than a threshold value;
determining, when the monitored transmission amount is greater than the threshold value, a presence/absence of an occurrence of system fault based on a system fault determination database representing a correspondence between a fault in the electric power system and a type of data transmitted in the network, and a type of the monitored data; and
stopping, when it is determined that the system fault occurs, the determination regarding whether or not the data amount is greater than the threshold value.

8. The network monitoring method according to claim 7, further comprising
determining, when it is determined that the system fault occurs, the presence/absence of the occurrence of system fault based on whether or not the monitored transmission amount is greater than a second threshold value which is greater than the threshold value.

9. The network monitoring method according to claim 8,
wherein the system fault determination database represents a correspondence between a type of fault in the electric power system and the type of data transmitted in the network;
when the monitored transmission amount is greater than the threshold value, the presence/absence of the occurrence of system fault and the type of fault are determined based on the type of the monitored data and the system fault determination database; and
the second threshold value corresponds to the determined type of the fault.

10. The network monitoring method according to claim 8,
wherein the network transmits communications among a plurality of types of devices; and
wherein the second threshold value corresponds to the type of the device.

11. The network monitoring method according to claim 8,
wherein the network is divided into a plurality of networks; and
wherein the second threshold value corresponds to each of the plurality of networks.

12. The network monitoring method according to claim 8, further comprising:
accumulating data transmitted in the network as trend data; and
deciding the threshold value and the second threshold value based on the accumulated trend data.
